# EUROPEAN PATENT APPLICATION

(11) **EP 4 610 218 A1**
(43) Date of publication of application: **03.09.2025**
(21) Application number: 24160042.8
(22) Date of filing: 27.02.2024
(51) Int. Cl.: B81C 99/00, B25J 7/00, B82B 3/00, G01Q 80/00, G01Q 70/06

(54) **SUPPORT SUBSTRATE COMPRISING A SET OF CANTILEVERS**

(71) Applicant: Chiral Nano AG, 8600 Dübendorf (CH)
(72) Inventor: EL ABBASSI, Maria, 8600 Dübendorf (CH)
(74) Representative: E. Blum & Co. AG

(57) **Abstract**

The invention refers to a support substrate (1) comprising a set of cantilevers (13), wherein each cantilever of the set of cantilevers (13) extends along a longitudinal axis in a direction from the support substrate (1) to a free end (130) of the cantilever. The free end (130) of each cantilever of the set of cantilevers (13) is adapted to load the nanostructure (2). The cantilevers of the set of cantilevers (13) are arranged along at least a curved or angular part of a circumference (11) of the support substrate (1). At least two cantilevers of the set of cantilevers (13) each extend in different directions.

## Description

### Technical Field

The invention refers to a support substrate comprising a set of cantilevers, wherein a free end of each cantilever of the set is adapted to load a nanostructure, an apparatus for transferring the nanostructures onto a device substrate, and a method for transferring the nanostructures by means of the apparatus.

### Background Art

Nanostructures are increasingly applied in nanoelectromechanical devices for a large variety of applications. In particular with respect to semiconductor devices, 2D nanostructures are expected to play an important role in the future.

A particular challenge in the fabrication of devices with nanostructures is the growth of individual nanostructures that are separated from each other and the correct transfer and attachment of the nanostructure from the growth substrate to the target device. In the prior art, a random or a parallel deposition of e.g. flakes onto a device substrate with a plurality of devices is usually applied.

With such a random deposition, however, a large part of the devices needs to be discarded, because none or too many nanostructures are deposited or the nanostructure is not correctly positioned on the device. As a result, the yield of devices when using such a random deposition procedure is rather low.

Use of single cantilevers to transfer a flake, e.g. a carbon flake, are demonstrated e.g. in Reference Frisenda, R. et al. "Recent Progress in the Assembly of Nanodevices and van der Waals Heterostructures by Deterministic Placement of 2D Materials", Chem. Soc. Rev., 2018, 47, 53.

### Disclosure of the Invention

The problem to be solved by the present invention is therefore to provide a support substrate, an apparatus and a method to transfer nanostructures in an industrial setting, in particular to enable sequential transfer of nanostructures.

This problem is solved by the invention in a first aspect referring to a support substrate, a second aspect referring to an apparatus and a third aspect of referring to a method.

Unless otherwise stated, the following definitions shall apply in this specification:
The terms **"a", "an," "the"** and similar terms used in the context of the present invention are to be construed to cover both the singular and plural unless otherwise indicated herein or clearly contradicted by the context. Further, the terms "including", "containing" and "comprising" are used herein in their open, non-limiting sense. The term "containing" shall include both, "comprising" and "consisting of".

Advantageously, the term **nanostructure** is regarded to be a structure of intermediate size between microscopic and molecular structures. Nanostructures comprise structures in the range of nanometers (typically 1-100nm). A nanostructure can have an elongated shape and be in the form of e.g., a nanotube or a nanowire. It can, however, also have a two-dimensionally extending shape and be in the form of e.g., a graphene variant, a transition-metal dichalcogenide layer or a boron nitride nanosheet. The nanostructures are preferably suspended or free-standing nanostructures.

Advantageously, the term **2D nanostructure** refers to nanostructures respectively nanomaterials that are composed of one or multiple thin layers. They might have a thickness of at least one atomic layer. Such materials might have a high aspect ratio (volume to surface-area). Examples of 2D nanostructures are nanosheets, nanoporous sheets, nanoplates, e.g consisting or comprising of graphene.

Advantageously, the term **cantilever** refers to a microcantilever or nanocantilever which is a widely used component in micro- and nanosystems. A cantilever is typically a beam constrained at one end, e.g. constrained to a support substrate, and freely oscillating the other end, pointing away from the substrate.

Advantageously, the term **support substrate** refers to a substrate that can be processed or micro-processed such that cantilevers can be fabricated directly into the substrate or can be adhered or added onto to the substrate.

Advantageously, the term **device substrate** refer to a microstructure or micromechanical structure (MEMS), in particular a structure that might be related to a specific functionality in the micro- or nanometer size.

Advantageously, the term **circumference** refers to the enclosing boundary of a curved geometric figure.

Advantageously, the term **moving in translational direction** refers to a movement of a body in which all points of the body move uniformly in the same direction.

The **first aspect** of the invention refers to a support substrate. Advantageously, the support substrate is adapted to transfer a nanostructure onto a device substrate. The support substrate comprises a set of cantilevers, wherein each cantilever of the set of cantilevers extends along a longitudinal axis in a direction from the support substrate to a free end of the cantilever. A free end of each cantilever of the set is adapted to load at least one nanostructure.

Advantageously, the transfer of the nanostructure happens by means of loading the free end of one or more cantilevers of the set of cantilevers with the nanostructure and then unloading the nanostructure from the respective beam onto a device substrate.

Therefore, further advantageously, the free end of each cantilever is further adapted to unload the nanostructure.

Advantageously, the longitudinal axis of each cantilever might extend along the longest extension of the cantilever.

The set of cantilevers might comprise two or more cantilevers. At least two cantilevers of the set of cantilevers each extend in different directions.

The cantilevers of the set are arranged along at least a curved or angular part of a circumference of the support substrate. The support substrate might therefore advantageously have a circular or polygonal shape. Further advantageously, the substrate might comprise multiple substrate segments that form together the substrate as referred to for the present invention.

Advantageously, loading the nanostructure refers to either picking up the nanostructure with the free beam or by means of growing the nanostructure directly on the respective cantilever or free end of the cantilever.

Advantageously, the attachment of the nanostructure to the free end of the cantilever happens e.g. by means of bringing the free beam in close contact with the nanostructure, e.g. by means of van der Waals forces, any other adherent forces, electrostatic forces, thermodynamic forces, chemical forces, etc.

Further advantageously, the growth of nanostructures on the cantilever respectively the free end of the cantilever might be initiated by the provision of a suitable catalyst at the respective positions of the support structure.

The cantilevers of the set of cantilevers then serve to transport the nanostructures to a device substrate, where the nanostructures are unloaded from the cantilever respectively from the free end of the cantilever.

By suspending the nanostructure onto a cantilever, the nanostructure can be engineered far from any device, in which it will be applied later on. In this way, the nanostructure can be produced in an optimal environment and with minimal charge noise originating from e.g. a semiconductor device interface.

By growing or depositing the suspended nanostructures onto a cantilever, it is also possible to pre-select the nanostructures to be used by means of an optical method applying laser technology. By means of such a pre-selection, quality of the used nanostructures can be ensured using a non-destructive optical method (e.g. Raman spectroscopy).

The growth substrate can then be approached to a device substrate, in order to transfer the pre-selected nanostructures to the devices, in which the nanostructures are to be used.

Advantageously, the unloading of the nanostructure refers to depositing the nanostructure onto a substrate device.

In particular, the loading and unloading of the nanostructure typically happens by means of van der Waals forces, any other adherent forces, electrostatic forces, thermodynamic forces, chemical forces, etc. Advantageously, the device substrate comprises a functional device and the unloaded nanostructure supplements or completes the functionality of the functional device.

The technical effect of having a set of cantilevers that are arranged along at least a curved or angular part of the circumference of the support substrate in such a way that the cantilevers of the set extend in different, directions, is that the support substrate can have a significantly larger number of cantilevers and, thus, of nanostructures held thereon compared to the support substrates known from prior art. Moreover, and even more importantly, the support substrate becomes scalable with regard to its size and number of cantilevers, because the mechanical collision between the support substrate and neighbouring devices can be avoided to a considerable extent, if the cantilevers of the set respectively their longitudinal axes extend in different directions. In the prior art, the cantilevers are usually all arranged individually as a single cantilever or if there are multiple cantilevers, they are arranged in parallel on one side of a rectangular support substrate. The disadvantage of such a prior art arrangement is that the cantilevers can collide with neighbouring devices, when a nanostructure is transferred to a device. Since the devices are usually evenly spaced in rows next to each other on a device substrate in the form of e.g., a wafer or a pallet, the parallel extending cantilever can easily collide with neighbouring devices, if the support substrate is scaled to a larger number of cantilevers that are all extending in parallel. Therefore, the usual production process according to the prior art has very limited scalability. In contrast, with the approach according to the invention, in which the sets of cantilevers are arranged along at least a curved or angular part of the circumference of the support substrate in such a way that they extend in different, directions, the provision of a larger support substrate with a larger number of cantilevers does not lead to collisions. Thus, the production process of the devices with the nanostructures, becomes scalable. A more efficient and therefore more cost-effective production of devices thus becomes possible.

Thus, due to the arrangement of the cantilevers of the set of cantilevers along at least a curved or angular part of the circumference of the support substrate, preferably even along the entire circumference, the number of cantilevers for transfer purposes can be increased significantly. In an advantageous embodiment, the support substrate has more than 1'000 cantilevers, in particular more than 3'000 cantilevers, very particular more than 5'000 cantilevers.

In an advantageous embodiment of the invention, the longitudinal axes of at least two cantilevers of the set of cantilevers are extending in non-parallel directions. This means that the at least two cantilevers of the set of cantilevers have each a longitudinal axis, wherein the two axes are not parallel to each other.

In a further advantageous embodiment of the invention, an angle γ between the at least two longitudinal axes of the at least two cantilevers of the set of cantilevers is γ ≥ 5°, in particular γ ≥ 30°, in particular γ ≥ 90°.

In a further advantageous embodiment of the invention, the cantilevers of the set of cantilevers are distributed along the entire circumference of the support substrate. The cantilevers might be equally distributed or might be distributed with various distances.

In the advantageous case of a circular support substrate this means that sections of the circumference, which are free of cantilever pairs, each span a circular arc of less than 90°, preferably less than 60°, more less than 45°, and most preferably less than 30°. In the case of a polygonal support substrate, a distribution of the plurality of cantilever pairs along the entire circumference means that each edge formed by the polygonal shape comprises at least one cantilever.

The technical effect of such an arrangement is to allow to rotate the support substrate around its central axis and thus using the different cantilevers attached to the substrate sequentially for transferring the nanostructures, while preventing collisions of the cantilevers as discussed above.

In a further advantageous embodiment of the invention, the longitudinal axis of the cantilevers of the set extends outwardly in an essentially radial direction with reference to a center axis of the support substrate. The center axis might refer to a symmetry axis or rotational axis of the support substrate. The extension of each cantilever is preferably along the horizontal direction, i.e. perpendicular to the direction of gravitation. Thus, each of the cantilevers preferably has an elongated bar- or rod-shaped design with a free end facing away from the support substrate.

An essentially radial direction is advantageously understood to be a direction which deviates from the exact radial direction by preferably less than 45°, more preferably less than 20°, most preferably less than 5°.

In a further advantageous embodiment of the invention, the circumference of the support substrate describes the overall shape of a circle or of a regular polygon. These regular geometric overall shapes of the support substrate are in particularly well suited with regard to scalability.

Advantageously, the support substrate is made as a whole in one piece.

Advantageously, in certain embodiments, the cantilevers can be made in one piece with the support substrate. In other embodiments, however, the cantilevers can be attached to the support substrate in such a way, that they are not made in one piece and e.g., are even made from a different material than the support substrate.

Advantageously the cantilevers of the set can be, but do not need to be uniformly distributed along the entire circumference of the support substrate.

Further advantageously, the support substrate might comprise a plurality of sections, wherein the plurality of sections is defined as the support substrate. Even if the plurality of sections are multiple pieces not touching each other, but are e.g. mounted onto a carrier substrate, they are providing the functionality and properties and features of the support substrate and are therefore defined and called support substrate.

The technical effect of providing a support substrate comprising a plurality of sections that are mounted onto a carrier substrate is that such an arrangement facilitates fabrication. Multiple substrate pieces comprising a subset of cantilevers might be manufactured. The substrate pieces might be mounted onto the carrier substrate and the arrangement of the multiple substrate pieces mounted onto the carrier substrate provides the same functionality as a support substrate that is made in one piece with the advantage, that the manufacturing of a substrate section with cantilevers is much easier than the manufacturing of the whole support substrate. The arrangement is also very flexible, since substrate sections might be exchanged or might have different properties, e.g. might be made of different materials etc.

For an advantageous embodiment thus, attaching a plurality of state-of-the-art support substrates, which each have a rectangular shape comprising a subset of cantilevers arranged in parallel on only one side thereof, to the circumference of a circular or rectangular carrier substrate, an inventive support substrate can be provided in a particularly easy way.

In a further advantageous embodiment of the invention, a pedestal between the subset of cantilevers and the support substrate provides a straight circumference in sections along the circumference of the support substrate. In particular, the pedestal and the cantilevers of the subset form a fork-like structure.

The technical effect of such a fork-like structure is that it allows to arrange a subset of cantilevers at along straight line, even though the whole support substrate might be circular. Such a setting might be advantageous, if a series of nanostructures is transferred from the cantilevers to a series of attachment points on a device substrate.

In such an advantageous embodiment, the distances between a first and a second neighbouring cantilever of the same subset might then be different and preferably smaller by an integral multiple than the distance between two cantilevers from different subsets of cantilevers.

Alternatively, or in addition, the subsets of cantilevers can also deviate from each other by the direction along which the longitudinal axes of two cantilevers from different subsets of the cantilevers extend. Advantageously, such a deviation might be an angel of not more than 10°, in particular of not more than 8°, in particular of not more than 6°, to each other.

Advantageously, within a subset of cantilevers, all longitudinal axes of the cantilevers extend in the same direction, meaning that they are all parallel to each other or essentially parallel to each other. In particular, essentially parallel means that the cantilevers of the subset are parallel to each other or nearly parallel to each other.

Further advantageously, the cantilevers in each set or subset of cantilevers are evenly spaced apart. The sets or subsets are advantageously uniformly distributed, i.e., at regular distances, and advantageously along the entire circumference of the support substrate.

In a further advantageous embodiment of the invention, the longitudinal axes of the cantilevers of a subset of cantilevers from the set of cantilevers are arranged parallel to each other.

Advantageously, a subset of cantilevers might comprise two or more cantilevers. In particular, the cantilevers of the subset are selected from the cantilevers of the set of cantilevers. Therefore, advantageously, the set of cantilevers comprises at least four cantilevers that form at least two subsets, each subset comprising at least two of the cantilevers of the set. In such an advantageous embodiment, the longitudinal axes of the two cantilevers in each subset are parallel to each other, wherein the longitudinal axis of one cantilever of the first subset and the longitudinal axis of one cantilever of the second subset are not directing in the same direction, in particular the two are non-parallel.

Advantageously, the technical effect of arranging the cantilevers in subgroups might be that the support substrate can be optimally adapted, with regard to the transfer of the nanostructures to the device substrate, on which the devices are usually evenly spaced in rows next to each other.

In a further advantageous embodiment of the invention, a plurality, in particular two or more, of the subsets of cantilevers are arranged at regular distances along the circumference, in particular along the entire circumference of the support substrate. Being arranged in regular distances here means in particular, that a distance between the middle of each subset has a certain regularity.

In a further advantageous embodiment of the invention, there is an angle α between the longitudinal axis of a cantilever of a first subset of cantilevers and the longitudinal axis of a cantilever of a second subset of cantilevers (131b), wherein α ≤ 90°, in particular α ≤ 30°, very particular α ≤ 6°.

In a further advantageous embodiment of the invention, each cantilever of the set of cantilevers comprises or consists of a material selected from the group of glass, polymer, metal and nitrides.

In a further advantageous embodiment of the invention, the cantilevers of the set of cantilevers are adapted to grow a nanostructure on their respective free end. Therefore, for such an embodiment, the support substrate respectively the cantilevers of the set of cantilevers do not only serve to transfer the nanostructures, but also to grow them. The support structure can in this case also be referred to as a growth structure that serves for the production of nanostructures. Growth of nanostructures on a cantilever respectively a cantilever free end can be initiated by the provision of a suitable catalyst at the respective positions of the cantilever. In other embodiments, the nanostructures are not grown on the cantilevers, but are dispersed in a solution, from which they are transferred or "fished" onto the cantilevers by immersing the cantilevers of the set of cantilevers in the solution. In yet another embodiment, the nanostructures are also not grown on the support structure respectively the cantilevers, but are deposited onto the cantilevers or respectively the free ends of the cantilevers, for example, by means of spraying.

In a further advantageous embodiment of the invention, at least one free end of a cantilever of the set of cantilevers comprises an interlayer or adhesion layer. In particular, the interlayer or adhesion layer is arranged on the site of the respective free end of the cantilever facing the nanostructure. The interlayer is adapted to load and/or unload a nanostructure by means of mechanical, thermal, and/or chemical forces.

An advantageous example transferring a nanostructure by means of loading and unloading the cantilever might be as following: Exfoliated van der Waals crystals (like graphene or hBN) can be mechanically transferred using an intermediate layer on the cantilever (typically the interlayer would be a polymer support like PDMS or a metallic thin film). The adhesion to the support substrate is performed by tuning the chemical composition as well as the thickness of the support samples. In the last step, the nanostructure is released on the receiving substrate by pressing the stack at for example higher temperature on the receiving substrate.

In a further advantageous embodiment of the invention, the cantilevers of the set of cantilevers are arranged in a plane. Thus, the extension of the support substrate along two perpendicular spatial directions is preferably at least a two-digit multiple, more preferably at least a three-digit multiple, greater than along a third perpendicular spatial direction. Advantageously, the set of cantilevers extends within a common plane. Thus, advantageously, the extension of all cantilevers is within the same plane and, more advantageously, within the same plane as the support substrate. In particular an upper and lower surface of each cantilever of the set of cantilever extends along the same plane as an upper and a lower surface of the support substrate.

A **second aspect** of the invention refers to an apparatus for transferring a nanostructure onto a device substrate. The apparatus comprises a manipulator for attaching the support substrate according to a first aspect of the invention, such that in can be transferred with the cantilevers of the support substrate to a device substrate. The manipulator itself is adapted to move the support substrate in at least one translational direction, in particular in three translational directions. The manipulator is further adapted to rotate the support substrate around the center axis and/or is further adapted to tilt the device substrate around an angle β with respect to the geometric normal (N) of a device substrate plane (P), in particular wherein β ≥ 3°, in particular β ≥ 10°, in particular wherein β ≥ 45°, in particular wherein β ≥ 90°.

Advantageously, the apparatus is adapted to move the support substrate holder and the positioner in such a way relative to each other, that the nanostructures, each held by a cantilever of the set of cantilevers, are brought from the support substrate to a plurality of attachment points on the device substrate, in order to be attached to the device substrate. The attachment points are the points where the nanostructures advantageously are to be attached.

Further advantageously, the apparatus is adapted to rotate the support substrate about an axis of rotation that extends perpendicularly through the common plane of the plurality of the set of cantilevers, in order to sequentially attach the nanostructures to the device substrate. By rotating the support substrate, the nanostructures might be sequentially placed onto the devices of the device substrate. A particularly simple and efficient fabrication of the device can therefore be achieved.

Advantageously, the idea of having a support substrate with a curved or angular circumference and with at least two cantilevers of a set of cantilevers that have longitudinal axes that each extend in a different, non-parallel direction, as indicated further above is directly linked with the idea to rotate the support substrate for transferring the nanostructures from the cantilevers respectively the tips of the cantilevers to the device on the device substrate.

Thus, the support substrate and the apparatus as indicated above relate to a single inventive concept.

In an advantageous embodiment, the apparatus is a motorized apparatus, meaning that the holder can be moved relatively to the positioner by means of a motor, in particular by means of an electric motor.

Further advantageously, the holder relates to a component of the apparatus, which allows attaching the support substrate to the apparatus.

Further advantageously, a positioner serves to position the device substrate such that the nanostructures can be safely and accurately transferred from the support substrate to the device substrate. Thus, the positioner preferably serves to hold the device substrate in the required position during the transfer.

In an advantageous embodiment, the holder is movable, in particular movable by a motor, while the positioner is stationary. It is also conceivable, however, that it is the other way around or that both the holder and the positioner are movable in other embodiments.

In a further advantageous embodiment, the axis of rotation is tilted or is tiltable with respect to the geometric normal of a device substrate plane in which the attachment points are arranged. Thus, the device substrate plane is defined by the arrangement of the attachment points. By tilting the axis of rotation with respect to the device substrate for the transfer of a nanostructure, a collision of the cantilevers with neighbouring devices can be avoided particularly well, while still ensuring a very accurate placing of the nanostructure on the device substrate. The tilt angle by which the axis of rotation is tilted or is tiltable with respect to the geometric normal of the device substrate plane is advantageously in the range from 1° to 40°, further advantageously in the range from 4° to 20°, further advantageously from 4° to 10°. A tilt angle in these ranges has been proven to be particularly well suited for avoiding collisions on the one hand and for ensure an accurate placing on the other hand.

Advantageously, the apparatus is adapted to move the support substrate relative to the positioner along an x-direction extending perpendicular to the axis of rotation. Further advantageously, the apparatus is adapted to move the support substrate relative to the positioner along a y-direction extending perpendicular to both the x-direction and the axis of rotation. In this way, nanostructures can efficiently be transferred to a multiple of device arranged next to each other.

A **third aspect** of the invention refers to a method to transfer one or more nanostructures, in particular 2D nanostructures, to a device substrate. Advantageously, the transfer is done by means of the apparatus according to the second aspect of the invention. To conduct the transfer method, a support substrate according to the first aspect of the invention is provided. The method comprising the steps:
a) loading at least one cantilever of the set with at least one nanostructures, and
b) releasing the at least one nanostructure onto an attachment point of the device substrate, and/or
c) rotating or translating the support substrate or the device substrate around a rotation axis, in particular rotating the support substrate around the center axis, in order to sequentially load and unload the respective at least one nanostructure and/or unload the respective at least one nanostructure onto a respective attachment point of the device substrate.

Further advantageously, the method comprises the steps of
a1) picking up the at least one nanostructure by bringing the tip of the cantilever of the set of cantilevers into close contact with the nanostructure, or
a2) growing the at least one nanostructure directly on the cantilever tip of each cantilever of the set of cantilevers.

A further advantageous method comprises the step of tilting the center axis around an angle angle β with respect to the geometric normal (N) of a device substrate plane (P), in particular wherein β ≥ 3°, in particular β ≥ 5°, in particular wherein β ≥ 10°, to obtain the picking up and/or releasing of the at least one nanostructure.

Other advantageous embodiments are listed in the dependent claims as well as in the description below.

### Brief Description of the Drawings

The invention will be better understood and objects other than those set forth above will become apparent from the following detailed description thereof. Such description makes reference to the annexed drawings, wherein:
Fig. 1a to 1d show different advantageous embodiments of the support structure according to a first aspect of the invention;
Fig. 2a to 2c show different steps of an advantageous embodiment of the method according to a third aspect of the invention;
Fig. 3a shows a schematic of an advantageous embodiment of an apparatus according to a second aspect of the invention;
Fig. 3b shows a section A of Fig. 3a;
Fig. 4 shows a sideview of the apparatus in Fig. 3 while the apparatus is in its intended use of transferring nanostructures; and
Fig. 5 shows a flow diagram of an embodiment of the method for transferring one or more nanostructures to a device substrate.

### Modes for Carrying Out the Invention

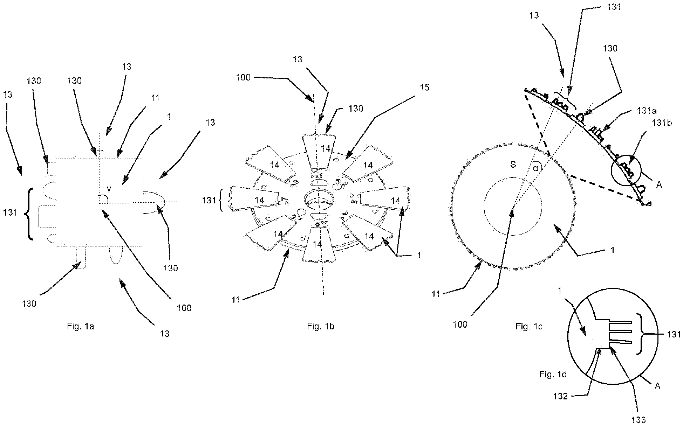

**Fig. 1a to 1c** show different advantageous embodiments of the support substrate 1 according to the first aspect of the invention.

**Fig. 1a to Fig. 1c** show all a support substrate 1 comprising a set of cantilevers 13. Each cantilever of the set of cantilevers 13 extends along a longitudinal axis in a direction from the support substrate 1 to a free end 130 of the cantilever. The free end 130 of each cantilever of the set 13 is adapted to load and/or unload a nanostructure 2. The cantilevers of the set 13 are arranged along at least a curved or angular part of a circumference 11 of the support substrate 1. At least two cantilevers of the set of cantilevers 13 each extend in different directions.

In the embodiment of **Fig. 1a****,** the support substrate has an angular circumference 11, respectively has a polygonal circumference 11, respectively a square circumference 11. The set of cantilevers 13 is distributed along the four sites of the square. Not every cantilever comprised by the support substrate 1 needs to be part of the set 13 of cantilevers 13, but at least two cantilevers of the set of cantilevers 13 have a longitudinal axis, wherein each axis extends in a different direction, in particular in an essentially non-parallel direction.

Advantageously, an angle γ between the at least two longitudinal axes of the at least two cantilevers of the set of cantilevers is γ ≥ 5°, in particular γ ≥ 30°, in particular γ ≥ 90°.

In the advantageous embodiment of the supporting structure 1 as shown in Fig. 1a, a plurality of subsets of cantilevers 131 is arranged at regular distances along the circumference 11, in particular along the entire circumference 11, of the supporting substrate 1. The longitudinal axes of the cantilevers of the subset 131 of the set of cantilevers 13 can be essentially parallel, as shown in Fig. 1a. A subset of cantilevers 131 here is formed by the cantilevers along each angular part, each edge, of the square.

**Fig. 1b** shows a further embodiment of the support substrate 1. The support substrate 1 comprises multiple support substrate sections 14, e.g. circular segments, that form the support substrate 1. Therefore, the support substrate 1 here is formed by a plurality of support substrate sections 14 that are attached to a carrier substrate 15.

A set of cantilevers 13 might comprise cantilevers from different support substrate sections 14. The longitudinal axes of at least two cantilevers of the set of cantilevers 13 each extend in different, in particular non-parallel directions.

In an advantageous embodiment of the supporting structure 1 as shown in Fig. 1b, a plurality of subsets of cantilevers 131 is arranged at regular distances along the in particular entire circumference 11 of the supporting substrate 1. The longitudinal axes of the cantilevers of the subset 131 of the set of cantilevers 13 can be essentially parallel, as shown in Fig. 1b. A subset of cantilevers 131 here is formed by the cantilevers along each substrate section 14 respectively each segment of a circle.

**Fig. 1c** shows a further embodiment of the support substrate 1. The support substrate 1 comprises one circular substrate 1. The radially extending subsets of cantilevers 131 are arranged at certain distances with respect to each other along the circumference 11 of the support substrate 1. A longitudinal axis of each cantilever might direct outwardly, essentially in a radial direction, wherein at least two cantilevers of the set 13 are arranged such that their longitudinal axes are directing in different direction, in particular are arranged in a non-parallel way.

Advantageously, cantilevers are made of the same material as the support substrate 1. In further advantageous embodiments, however, it is also possible that the cantilevers are made of a different material or different piece of material than the support substrate 1.

In an advantageous embodiment of the supporting structure 1 as shown in Fig. 1c, a plurality of subsets of cantilevers 131 is arranged at regular distances along the in particular entire circumference 11 of the support substrate 1. The longitudinal axes of the cantilevers of the subset 131 of the set of cantilevers 13 can be essentially parallel, as shown in Fig. 1c. A subset of cantilevers 131 here is formed by the cantilevers along each portion 15 extending from the main portion 14.

Fig. 1d shows the detail A of Fig. 1c. It is shown that a pedestal 132 between the subset of cantilevers 131 and the support substrate provides a straight circumference in sections along the circumference 11 of the support substrate 1.

For all the advantageous embodiments of Fig. 1a to 1c, the cantilevers of the set of cantilevers 13 might be distributed along the entire circumference 11 of the support substrate 1. Further advantageously, each longitudinal axis of the cantilevers of the set 13 might extend outwardly in an essentially radial direction with reference to a center axis 100 of the respective support substrate 1.

For alle the advantageous embodiments of Fig. 1a to Fig. 1c, an angle γ between the at least two longitudinal axes of the at least two cantilevers of the set of cantilevers is γ ≥ 5°, in particular γ ≥ 30°, in particular γ ≥ 90°.

For all the advantageous embodiments of Fig. 1a to 1c, a plurality of subsets of cantilevers 131 is arranged at regular distances along the circumference 11, in particular along the entire circumference 11 of the support substrate 1.

Further advantageously, a plurality of subsets of cantilevers might be arranged such that there might be an angle α between the longitudinal axis of a cantilever of a first subset of cantilevers 131a and the longitudinal axis of a cantilever of a second subset of cantilevers 131b, wherein α ≤ 90°, in particular α ≤ 30°, very particular α ≤ 6°.

Further advantageously, each cantilever of the set of cantilevers of the embodiments as shown in Fig. 1a to 1c comprises or consists of a material selected from the group of glass, polymer, metal and nitrides.

Further advantageously, the cantilevers of the set of cantilevers 13 as shown in Fig. 1a to 1c are adapted to grow at least one nanostructure 2 on their respective free end 130. Further advantageously, at least one free end 130 of a cantilever of the set of cantilevers 13 comprises an interlayer or adhesion layer. In particular, the interlayer or adhesion layer is arranged on the site of the free end facing the nanostructure when loading or unloading the free end 130.

In a further advantageous embodiment of the invention, the cantilevers of the set of cantilevers are arranged in one plane. This is also true for the sets of cantilevers as shown in Fig. 1a to 1c. In Fig. 1b, the cantilevers are provided support substrate sections 14 that are attached to a carrier substrate 15. Still, the cantilevers of the set 13, which comprises at least two cantilevers of all cantilevers as shown, are still arranged in one plane.

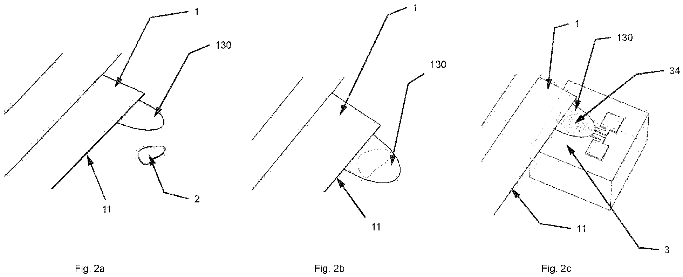

**Fig. 2a to 2c** show the application of the supporting substrate respectively of one cantilever of a set of cantilevers provided by the substrate in its intended use. In the intended use of the supporting substrate, a cantilever of the set of cantilevers 13 loads a nanostructure 2 on its tip 130. The loading might happen as described before, e.g. by means of bringing the free beam in close contact with the nanostructure, e.g. by means of van der Waals forces, any other adherent forces, electrostatic forces, thermodynamic forces, chemical forces, etc.

**Fig. 2b** shows the free end 130 of the cantilever of the set 13 loaded with the nanostructure 2. In Fig. 2c, the nanoparticle 2 is unloaded onto an attachment point 34 on the device substrate 3. The attachment point 34 in Fig. 2c is shown in dotted lines.

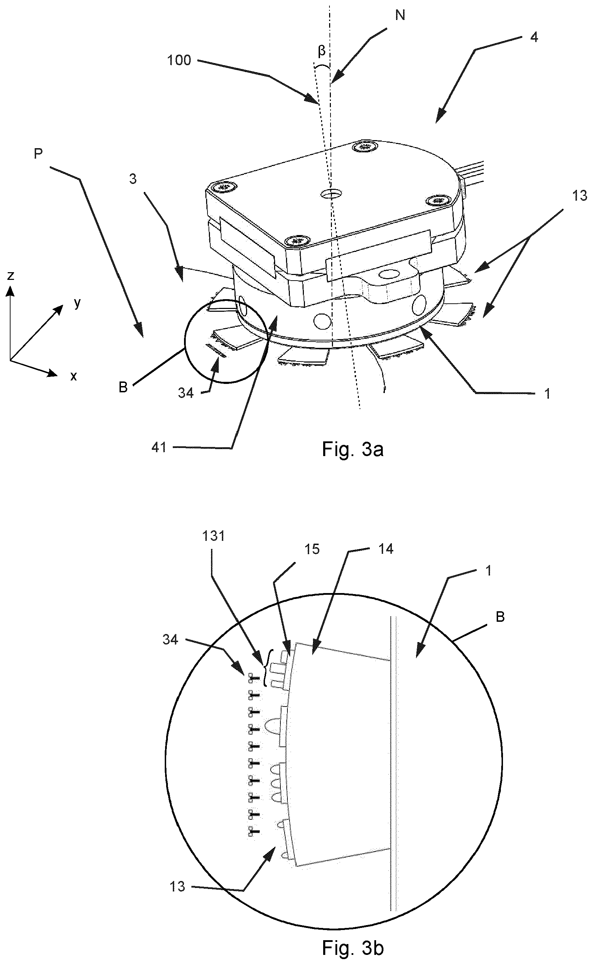

**Fig. 3a** shows an advantageous embodiment of the apparatus 4 according to a second aspect of the invention. The apparatus 4 is adapted to transfer a nanostructure 2 onto a device substrate 3. The apparatus 4 comprises a manipulator 41 for attaching the support substrate 1 according to the first aspect of the invention. The manipulator 41 is adapted to move the support substrate 1 in at least one translational direction x, y or z, in particular, it is adapted to move the support substrate 1 in all three translational directions. Furthermore, the manipulator is adapted to rotate the support substrate 1 around the center axis 100 and/or wherein the manipulator is further adapted to tilt the device substrate around an angle β with respect to the geometric normal (N) of a device substrate plane (P), in particular wherein β ≥ 3°, in particular wherein β ≥ 90°, in particular β ≥ 45°, in particular wherein β ≥ 90°.

**Fig. 3b** shows a section B of Fig. 3a. A section 14 of a support substrate is visible comprising a subset of cantilevers 131. Some of the subset of cantilevers 131 are aligned with the respective attachment points 34 of the device substrate 3. Nanostructures 2 that are loaded on the respectively cantilevers of the subsets can now be transferred to the nanostructures 2. The rotation of the support substrate 1 with the apparatus 4 can align the respective subset of cantilevers 131 with the respective attachment point 34.

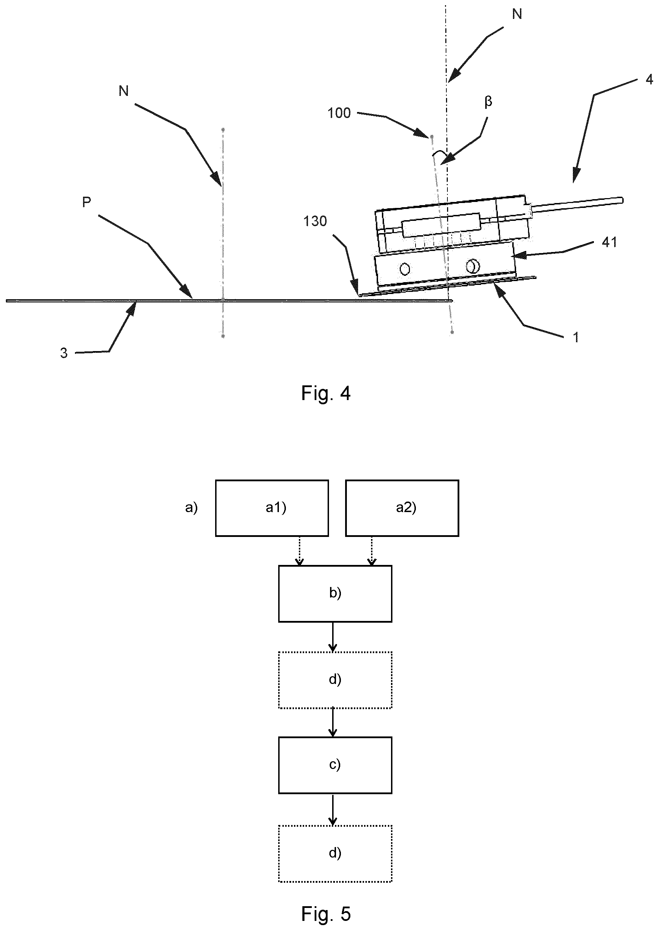

**Fig. 4** shows a sideview of the apparatus as shown in Fig. 3. The tilting of the apparatus 4 vs. the device substrate plane P is shown in the sideview. The apparatus 4 is shown in a position where a subset of the cantilevers 131 is oriented such that it aligns above an attachment point 34 of the device substrate 3.

**Fig. 5** shows a flow diagram for a method to transfer one or more nanostructures 2, in particular 2D nanomaterials or nanostructures, to a device substrate 3. The transfer is done in particular by an apparatus as shown in Fig. 3 and Fig. 4, in particular with one of the support substrates as shown in Fig. 1a to 1c. The method comprises the steps:
a) Loading at least one cantilever of the set 13 with at least one nanostructure 2;

Advantageously, the loading can be processed by (the dashed arrows mean that the steps can be run alternatively):
a1) Picking up the at least one nanostructure by bringing the tip 130 of the cantilever of the set of cantilevers 130 into close contact with the nanostructure, or
a2) Growing the at least one nanostructure directly on the cantilever tip 130 of each cantilever of the set of cantilevers 13.

Further steps of the method are:
b) Unloading the at least one nanostructure onto an attachment point (30) of the device substrate (3); and/or
c) Rotating or translating the support substrate (1) or the device substrate around a rotation axis, in particular rotating the support substrate 1 around the center axis (100), in order to sequentially load the respective at least one nanostructure and/or unload the respective at least one nanostructure onto a respective attachment point (30) of the device substrate.

Further advantageously, the method can comprise the step:
d) Tilting the center axis (100) around an angle β with respect to the geometric normal (N) of a device substrate plane (P), in particular wherein β ≥ 3°, in particular β ≥ 5°, in particular wherein β ≥ 10°, to obtain the picking up and/or releasing of the at least one nanostructure.

The step d) might advantageously be in the order before and/or after step c) (this indicated with the dashed lines of the respective boxes).

### References

- 1: Support substrate
- 100: Center axis of support substrate
- 11: Circumference of substrate
- 13: Set of cantilevers
- 14: Support substrate sections
- 15: Carrier substrate
- 130: Tip of cantilever
- 131: Subset of cantilevers
- 131a: First subset of cantilevers
- 131b: Second subset of cantilevers
- 132: Pedestal
- 133: Straight circumference
- 2: Nanostructure
- 3: Device substrate
- 34: Attachment point
- 4: Apparatus
- 41: Manipulator
- α: Angle between longitudinal axes of two subsets
- β: Angle between N and P
- N: Geometric normal
- P: Device substrate plane

## Claims

1. A support substrate (1) comprising a set of cantilevers (13),
wherein each cantilever of the set of cantilevers (13) extends along a longitudinal axis in a direction from the support substrate (1) to a free end (130) of the cantilever,
wherein the free end (130) of each cantilever of the set of cantilevers (13) is adapted to load a nanostructure (2),
wherein the cantilevers of the set of cantilevers (13) are arranged along at least a curved or angular part of a circumference (11) of the support substrate (1),
wherein at least two cantilevers of the set of cantilevers (13) each extend in different directions.

2. The support substrate according to claim 1, wherein the longitudinal axes of at least two cantilevers of the set of cantilevers (13) are extending in non-parallel directions.

3. The support substrate according to one of the preceding claims, wherein an angle γ between the at least two longitudinal axes of the at least two cantilevers of the set of cantilevers (13) is γ ≥ 5°, in particular γ ≥ 30°, in particular γ ≥ 90°.

4. The support substrate (1) according to one of the preceding claims, wherein the cantilevers of the set of cantilevers (13) are distributed along the entire circumference (11) of the support substrate (1).

5. The support substrate (1) according to one of the preceding claims, wherein the longitudinal axes of the cantilevers of a subset of cantilevers (131) from the set of cantilevers (13) are arranged essentially parallel to each other.

6. The support substrate (1) according to claim 5, wherein a plurality of subsets of cantilevers (131) is arranged at regular distances along the circumference (11), in particular along the entire circumference (11) of the support substrate (1).

7. The support substrate (1) according to claim 5 or 6, wherein there is an angle α between the longitudinal axis of a cantilever of a first subset of cantilevers (131a) and the longitudinal axis of a cantilever of a second subset of cantilevers (131b), wherein α ≤ 90°, in particular α ≤ 30°, very particular α ≤ 6°.

8. The support substrate (1) according to one of the preceding claims, wherein each cantilever of the set of cantilevers (13) comprises or consists of a material selected from the group of glass, polymer, metal and nitrides.

9. The support substrate (1) wherein the cantilevers of the set of cantilevers (13) are adapted to grow at least one nanostructure on their respective free end (130) .

10. The support substrate (1) according to one of the preceding claims, wherein at least one free end (130) of a cantilever of the set of cantilevers (13) comprises an interlayer, in particular the interlayer is arranged on the site of the free end facing the nanostructure (2), wherein the interlayer is adapted to load and/or unload a nanostructure (2) by means of Van der Waals forces, mechanical, thermal, and/or chemical forces.

11. The support substrate (1) according to one of the preceding claims, wherein the cantilevers of the set of cantilevers (13) are arranged in one plane.

12. The support substrate (1) according to one of the preceding claims, wherein the support substrate (1) is formed by a plurality of support substrate sections (14) in particular, wherein the support substrate sections (14)t are attached to a carrier substrate (15).

13. The support substrate (1) according to one of the preceding claims, wherein a pedestal (132) between the subset of cantilevers (131) and the substrate (1) provides a straight circumference (133) in sections along the circumference (11) of the support substrate (1).

14. Apparatus (4) for transferring a nanostructure (2) onto a device substrate (3) comprising a manipulator (41) for attaching the support substrate (1) according to one of the preceding claims,
wherein the manipulator (41) is adapted to move the support substrate in at least one translational direction, in particular in three translational directions,
wherein the manipulator is adapted to rotate the support substrate (1) around the center axis (100), and/or
wherein the manipulator is further adapted to tilt the device substrate around an angle β with respect to the geometric normal (N) of a device substrate plane (P), in particular wherein β ≥ 3°, in particular β ≥ 45°, in particular wherein β ≥ 90°.

15. Method to transfer one or more nanostructures, in particular 2D material nanostructures, to a device substrate (3), in particular by means of an apparatus (4) according to claim 14, providing a support substrate according to one of the preceding claims 1 to 11, comprising:
a) Loading at least one cantilever of the set (13) with at least one nanostructure (2), and
b) Unloading the at least one nanostructure onto an attachment point (30) of the device substrate (3), and/or
c) Rotating or translating the support substrate (1) or the device substrate around a rotation axis, in particular rotating the support substrate (1) around the center axis (100), in order to sequentially load the respective at least one nanostructure and/or unload the respective at least one nanostructure onto a respective attachment point (30) of the device substrate.

16. Method according to claim 15, wherein the loading step is:
a1) Picking up the at least one nanostructure by bringing the tip (130) of the cantilever of the set of cantilevers (130) into close contact with the nanostructure, or
a2) Growing the at least one nanostructure directly on the cantilever tip (130) of each cantilever of the set of cantilevers (13).

17. Method according to claim 15 or 16, comprising further:
e) Tilting the center axis (100) around an angle β with respect to the geometric normal (N) of a device substrate plane (P), in particular wherein β ≥ 3°, in particular β ≥ 5°, in particular wherein β ≥ 10°, to obtain the picking up and/or releasing of the at least one nanostructure.
